# EUROPÄISCHE PATENTANMELDUNG

(11) **EP 4 446 019 A1**
(43) Veröffentlichungstag der Anmeldung: **16.10.2024**
(21) Anmeldenummer: 24154444.4
(22) Anmeldetag: 29.01.2024
(51) Int. Cl.: B05D 1/00, C23C 16/453, D06Q 1/00, C23C 16/00, C23C 18/00, C23C 16/50, D06M 10/02, D06M 10/10, D21H 19/00

(54) **VERFAHREN ZUR HERSTELLUNG ANORGANISCH-ORGANISCHER HYBRIDPOLYMER-BESCHICHTUNGEN SOWIE MIT DEM VERFAHREN HERSTELLBARES BESCHICHTETES SUBSTRAT**

(30) Priorität: 14.02.2023 DE 102023103573
(71) Anmelder: Fraunhofer-Gesellschaft zur Förderung der angewandten Forschung e.V., 80686 München (DE)
(72) Erfinder: ROSE, Klaus, 97082 Würzburg (DE); GLÖß, Daniel, 01277 Dresden (DE); NIZARD, Harry, 01277 Dresden (DE)
(74) Vertreter: Pfenning, Meinig & Partner mbB

(57) **Zusammenfassung**

Die vorliegende Erfindung betrifft ein Verfahren zur Herstellung anorganischorganischer Hybridpolymer-Beschichtungen, bei welchem verschiedene (monomere) Ausgangskomponenten für mindestens ein anorganisch-organisches Hybridpolymer verdampft oder vernebelt werden, die verdampften oder vernebelten (monomeren) Ausgangkomponenten separat voneinander in eine Beschichtungskammer eingebracht werden, und ein Plasma-unterstützter oder pyrolytisch unterstützter chemischer Gasphasenabscheidung-Prozess in der Beschichtungskammer durchgeführt wird, bei welchem mindestens eine anorganisch-organische Hybridpolymerbeschichtung erhalten wird, indem die (verschiedenen) in die Beschichtungskammer eingebrachten (monomeren) Ausgangskomponenten zu mindestens einer vernetzbaren Vorstufe des mindestens einen anorganisch-organischen Hybridpolymers umgesetzt werden, die mindestens eine vernetzbare Vorstufe zum mindestens einen anorganisch-organischen Hybridpolymer vernetzt wird, und die (verschiedenen) in die Beschichtungskammer eingebrachten (monomeren) Ausgangskomponenten, die mindestens eine vernetzbare Vorstufe des mindestens einen anorganisch-organischen Hybridpolymers und/oder das mindestens einen anorganisch-organischen Hybridpolymer auf mindestens einer Oberfläche eines Substrats abgeschieden werden. Im Weiteren betrifft die vorliegende Erfindung auch ein beschichtetes Substrat, welches ein Substrat mit mindestens einer anorganisch-organischen Hybridpolymer-Beschichtung umfasst und mit dem erfindungsgemäßen Verfahren herstellbar oder hergestellt ist.

## Beschreibung

Die vorliegende Erfindung betrifft ein Verfahren zur Herstellung anorganisch-organischer Hybridpolymer-Beschichtungen, bei welchem verschiedene (monomere) Ausgangskomponenten für mindestens ein anorganisch-organisches Hybridpolymer verdampft oder vernebelt werden, die verdampften oder vernebelten (monomeren) Ausgangkomponenten separat voneinander in eine Beschichtungskammer eingebracht werden, und ein Plasma-unterstützter oder pyrolytisch unterstützter chemischer Gasphasenabscheidung-Prozess in der Beschichtungskammer durchgeführt wird, bei welchem mindestens eine anorganisch-organische Hybridpolymerbeschichtung erhalten wird, indem die (verschiedenen) in die Beschichtungskammer eingebrachten (monomeren) Ausgangskomponenten zu mindestens einer vernetzbaren Vorstufe des mindestens einen anorganisch-organischen Hybridpolymers umgesetzt werden, die mindestens eine vernetzbare Vorstufe zum mindestens einen anorganisch-organischen Hybridpolymer vernetzt wird, und die (verschiedenen) in die Beschichtungskammer eingebrachten (monomeren) Ausgangskomponenten, die mindestens eine vernetzbare Vorstufe des mindestens einen anorganisch-organischen Hybridpolymers und/oder das mindestens einen anorganisch-organischen Hybridpolymer auf mindestens einer Oberfläche eines Substrats abgeschieden werden. Im Weiteren betrifft die vorliegende Erfindung auch ein beschichtetes Substrat, welches ein Substrat mit mindestens einer anorganisch-organischen Hybridpolymer-Beschichtung umfasst und mit dem erfindungsgemäßen Verfahren herstellbar oder hergestellt ist.

Über den Sol-Gel-Prozess ist es möglich, hybride Materialien herzustellen, wobei die Dimension der primären Reaktionsprodukte im Bereich einiger Nanometer liegt. Diese nanoskaligen Cluster, kolloidal-dispers verteilt im Lösemittel, bilden das Kernelement von hybriden Beschichtungsmaterialien. Die Herstellung erfolgt durch Hydrolyse- und Kondensationsreaktionen von metallischen Alkoxidverbindungen oder organisch substituierten Kieselsäureestern in Lösung. Das Verfahren ermöglicht die Synthese von multifunktionellen Schichten über nasschemische Verfahren, wobei durch chemische Verknüpfung aller Komponenten untereinander, die Wirksamkeit dieser Funktionen permanent erhalten bleibt. Die über chemische Modifikation prinzipiell erzielbaren und beschriebenen Eigenschaften umfassen Kratzschutz, farbige Dekoration, Leitfähigkeit, Antistatik, Barriere- und easy-to-clean Wirkung sowie Photochromie.

Die inzwischen weitestgehend etablierte und eingesetzte Technologie auf Basis von Sol-Gel-Materialien beschränkt sich allerdings auf deren Einsatz als Nasslack in herkömmlichen Lackier- und Beschichtungsverfahren. Die Herstellung erfolgt durch Hydrolyse und Kondensationsreaktionen von metallischen Alkoxidverbindungen oder organisch substituierten Kieselsäureestern in Lösung. Der Schichtaufbau erfolgt dann durch übliche Nasslackverfahren mit einer abschließenden Härtungsprozedur. Es ergibt sich somit folgender Mehrstufenprozess:

| | |
|---|---|
| • Hydrolyse- und Kondensationsreaktion zum anorganischen Präpolymer | (Stufe 1) |
| • Schichtauftrag mit verschiedenen "Nassfilm"-Verfahren | (Stufe 2) |
| (Sprühen, Tauchen, Schleudern,...) | |
| • Schichthärtung mittels Wärme oder UV-Strahlungseinfluss unter Zuhilfenahme von Härtungs- oder Polymerisationsinitiatoren | (Stufe 3) |

PECVD-Prozesse (plasmaunterstützte chemische Gasphasenabscheidung) bieten dagegen die Möglichkeit zur Herstellung von besonders dünnen, hochreinen und homogenen Schichten. Bei der plasmagestützten Abscheidung organischer und anorganischer Polymerschichten werden aus niedermolekularen Monomeren Polymerschichten gebildet. Dabei können die Schichteigenschaften über die Precursorzusammensetzung, reaktive Prozessgase und die Plasmaparameter beeinflusst werden. Plasmapolymere werden heutzutage unter Nutzung vielfältiger Prozessvarianten (z.B. HF/LF-PECVD, Magnetron-PECVD, DC-PECVD) beispielsweise für Barriere-, Kratzschutz- und wasserabweisende Schichten eingesetzt.

Oberflächen- und Schichttechnologien zeichnen sich durch zunehmende Bedeutung in nahezu allen Branchen und Lebensbereichen aus. Oberflächentechnik optimiert die Eigenschaften von Halbzeugen, Bauteilen, Werkzeugen oder Gebrauchsgegenständen und führt diese neuen Anwendungen zu. Die Oberflächentechnologie ist dabei in vielen Fällen eine Kombination aus Materialinnovation und neuen Applikations- und Verarbeitungstechnologien.

In vielen Bereichen der Oberflächentechnik haben sich inzwischen hybridpolymere Schichtmaterialien etabliert und werden bisher im weit verbreiteten Sol-Gel-Verfahren hergestellt. Bei dieser nasschemischen Verarbeitung wird in einer Lösung zunächst ein anorganisches Grundgerüst aufgebaut, das nach dem Schichtauftrag über eingebaute Reaktivgruppen durch organische Polymerisation quervernetzt wird. Dieses zweistufige Verfahren kann bei der langsam stattfindenden anorganischen Netzwerkbildung jedoch nicht in allen Anwendungsgebieten genutzt werden. Eine prinzipielle Einschränkung ergibt sich weiterhin bei der im zweiten Schritt initiierten organischen Polymerisation im Nassfilm, da die im ersten Schritt gebildeten anorganischen Strukturen eine komplette organische Polymerisation sterisch behindern können.

Zudem besteht eine zusätzliche Problematik in der teilweise geringen Lagerstabilität der Sol-Gel-Schichtsysteme, bedingt durch eine einsetzende Polymerisation im ersten Syntheseschritt zum anorganischen Prä-Polymernetzwerk, das oftmals nicht ausreichend stabilisiert werden kann und eine Tendenz zur Vergelung aufweist.

Ausgehend hiervon war es die Aufgabe der vorliegenden Erfindung ein Verfahren zur Herstellung von anorganisch-organischen Hybridpolymer-Beschichtungen anzugeben, mit welchem auf kostengünstige und zeitsparende Weise Beschichtungen mit vorteilhaften Eigenschaften hergestellt werden können.

Diese Aufgabe wird bezüglich eines Verfahrens zur Herstellung anorganisch-organischer Hybridpolymer-Beschichtungen mit den Merkmalen des Patentanspruchs 1 und bezüglich eines beschichteten Substrats mit den Merkmalen des Patentanspruchs 14 gelöst. Die abhängigen Patentansprüche stellen vorteilhafte Weiterbildungen dar.

Erfindungsgemäß wird somit ein Verfahren zur Herstellung anorganisch-organischer Hybridpolymer-Beschichtungen angegeben, bei welchem
a) verschiedene (monomere) Ausgangskomponenten (bzw. Ausgangsverbindungen) für mindestens ein anorganisch-organisches Hybridpolymer (separat voneinander) verdampft oder vernebelt werden,
b) die (verschiedenen) verdampften oder vernebelten (monomeren) Ausgangskomponenten (bzw. Ausgangsverbindungen) separat voneinander in eine Beschichtungskammer eingebracht (und dort gemischt) werden, und
c) ein Plasma-unterstützter oder pyrolytisch unterstützter chemischer Gasphasenabscheidung-Prozess in der Beschichtungskammer durchgeführt wird, bei welchem (bzw. durch welchen) mindestens eine anorganisch-organische Hybridpolymerbeschichtung erhalten wird, indem (durch den Plasma-unterstützten oder pyrolytisch unterstützten chemischen Gasphasenabscheidung-Prozess)
   - die (verschiedenen) in die Beschichtungskammer eingebrachten (monomeren) Ausgangskomponenten (Ausgangsverbindungen) zu mindestens einer vernetzbaren Vorstufe des mindestens einen anorganisch-organischen Hybridpolymers umgesetzt werden,
   - die mindestens eine vernetzbare Vorstufe zum mindestens einen anorganisch-organischen Hybridpolymer vernetzt wird, und
   - die (verschiedenen) in die Beschichtungskammer eingebrachten (monomeren) Ausgangskomponenten, die mindestens eine vernetzbare Vorstufe des mindestens einen anorganisch-organischen Hybridpolymers und/oder das mindestens eine anorganisch-organische Hybridpolymer auf mindestens einer Oberfläche eines Substrats abgeschieden wird/werden.

Erfindungsgemäß erfolgt bei dem Plasma-unterstützten oder pyrolytisch unterstützten chemischen Gasphasenabscheidungs-Prozess (bzw. durch den Plasma-unterstützten oder pyrolytisch unterstützten chemischen Gasphasenabscheidung-Prozess) in Schritt c)
- die Umsetzung der (verschiedenen) in die Beschichtungskammer eingebrachten (monomeren) Ausgangskomponenten (Ausgangsverbindungen) zu mindestens einer vernetzbaren Vorstufe des mindestens einen anorganisch-organischen Hybridpolymers,
- die Vernetzung der mindestens einen vernetzbaren Vorstufe zum mindestens einen anorganisch-organischen Hybridpolymer, und
- die Abscheidung der (verschiedenen) in die Beschichtungskammer eingebrachten (monomeren) Ausgangskomponenten und/oder der mindestens einen vernetzbaren Vorstufe des mindestens einen anorganisch-organischen Hybridpolymers und/oder des mindestens einen anorganisch-organischen Hybridpolymers auf der mindestens einen Oberfläche des Substrats,
sodass bei dem Plasma-unterstützten oder pyrolytisch unterstützten chemischen Gasphasenabscheidungs-Prozess (bzw. durch den Plasma-unterstützten oder pyrolytisch unterstützten chemischen Gasphasenabscheidung-Prozess) mindestens eine anorganisch-organische Hybridpolymerbeschichtung erhalten wird.

Die Reaktionen in Schritt c) - d.h. die Umsetzung der (verschiedenen) in die Beschichtungskammer eingebrachten (monomeren) Ausgangskomponenten (bzw. Ausgangsverbindungen) zur mindestens einen vernetzbaren Vorstufe des mindestens einen anorganisch-organischen Hybridpolymers und/oder die Vernetzung der mindestens einen vernetzbaren Vorstufe zum mindestens einen anorganisch-organischen Hybridpolymer kann/können erfolgen im Plasma-/CCVD-Raum oder auf der Substratoberfläche, während das Plasma/die Flamme noch auf die Substratoberfläche bzw. die noch nicht zugedeckte Schicht einwirkt.

Die Umsetzung der (verschiedenen) Beschichtungskammer eingebrachten (monomeren) Ausgangskomponenten (bzw. Ausgangsverbindungen) zur mindestens einen vernetzbaren Vorstufe des mindestens einen anorganisch-organischen Hybridpolymers und/oder das Vernetzen der mindestens einen vernetzbaren Vorstufe zum mindestens einen anorganisch-organischen Hybridpolymer kann vor, während und/oder nach der Abscheidung auf der mindestens einen Oberfläche des Substrats erfolgen.

Im erfindungsgemäßen Verfahren können durch den Einsatz verschiedenen (monomerer) Ausgangsverbindungen bzw. Ausgangskomponenten in Kombination mit einem Plasma-unterstützten (Plasma-Enhanced Chemical Vapor Deposition - PECVD) oder pyrolytisch unterstützten CVD-Verfahren (Combustion Chemical Vapor Deposition - CCVD) hochvernetzte hybridpolymere Beschichtungssysteme direkt auf den Zielsubstraten abgeschieden werden, ohne den mehrstufigen Sol-Gel-Weg mit zusätzlicher nasschemischer Beschichtungstechnologie zu beschreiten.

Die verschiedenen Ausgangskomponenten bzw. Ausgangsverbindungen für das mindestens eine anorganisch-organische Hybridpolymer können auch als verschiedene Precursor für das für das mindestens eine anorganisch-organische Hybridpolymer bezeichnet werden.

Erfindungsgemäß werden mindestens zwei, vorzugsweise mindestens drei, verschiedene Ausgangskomponenten bzw. Ausgangsverbindungen bzw. Precusor für das mindestens eine anorganisch-organische Hybridpolymer im Verfahren eingesetzt, d.h. in Schritt a) verdampft oder vernebelt.

Das erfindungsgemäße Verfahren zeichnet sich vor alle dadurch aus, dass die erste Vernetzung bzw. Vorvernetzung der verschiedenen (monomeren) Ausgangskomponenten zu mindestens einer vernetzbaren Vorstufe des mindestens einen anorganisch-organischen Hybridpolymers, der Schichtauftrag und die zweite Vernetzung bzw. Endvernetzung bzw. Aushärtung der mindestens einen vernetzbaren Vorstufe zum mindestens einen anorganisch-organischen Hybridpolymer innerhalb eines einzigen Verfahrensschritts - nämlich in Schritt c) des erfindungsgemäßen Verfahrens, d.h. bei dem Plasma-unterstützten oder pyrolytisch unterstützten chemischen Gasphasenabscheidung-Prozess in der Beschichtungskammer - durchgeführt werden. So können im Vergleich zum bisher bekannten Sol-Gel-Verfahren sowohl Zeit als auch Energie und damit Kosten eingespart werden. Zudem können durch die Verwendung des Plasma-unterstützten oder pyrolytisch unterstützten chemischen Gasphasenabscheidungs-Prozesses anorganisch-organisch Hybridpolymer-Beschichtungen mit sehr vorteilhaften und teilweise bisher nicht umsetzbaren Eigenschaften erhalten werden.

Bei dem neuartigen Konzept werden die (monomeren) Ausgangsverbindungen, die ursprünglich aus der Sol-Gel-Chemie bekannt sind, jeweils separat (und vorzugsweise lösemittelfrei) verdampft oder zerstäubt bzw. vernebelt und separat in die Beschichtungskammer eingebracht, sodass sie erst in der Beschichtungskammer gemischt werden. Hierdurch wird erreicht, dass die (monomeren) Ausgangsverbindungen tatsächlich erst in der Beschichtungskammer, vorzugsweise in der Nähe des Substrats, miteinander reagieren.

Zur Anwendung kommt dabei vorzugsweise ein angepasstes mehrkanaliges Verdampfersystem oder Vernebelungs-/Einspritzsystem, welches Verdampfungstemperaturen bis 250°C ermöglicht.

Ein wesentlicher Vorteil des erfindungsgemäßen Verfahrens liegt darin, dass die anorganische Vor- und die organische Endvernetzung jetzt nicht örtlich und zeitlich getrennt stattfinden, sondern in einem Prozess bzw. in einem einzigen Verfahrensschritt - nämlich während Schritt c) des erfindungsgemäßen Verfahrens - und unter intensiver Energiezufuhr erfolgen. Somit eröffnen sich neue Reaktionswege und daraus resultierend neue Strukturen und Materialeigenschaften.

Die Verwendung derartiger mehrkanaliger Verdampfersysteme oder Vernebelungs-/ Einspritzsystemen ist in den Bereichen Niederdruck-PECVD und Flammenpyrolyse neu und eröffnet dadurch die Möglichkeit zur Verwendung vollkommen neuer Precursoren und Precursormischungen. Nicht nur durch die neuen Precursoren, die zum Einsatz kommen, auch durch die Möglichkeit der Einstellung des Mischungsverhältnisses, eröffnen sich eine Vielzahl neuer Anwendungsfelder - ein Sachverhalt häufig gewünscht ist, bisher aber nicht realisiert werden konnte. Durch die bisher eingesetzte Technik ist man auf wenige Precursoren mit niedrigem Siedepunkt und hohem Dampfdruck beschränkt. Es könnten über die Flammenpyrolyse somit nicht nur Schichten bekannter Materialbasis mit neuen Struktur- und Materialeigenschaften erzeugt werden, sondern es besteht die Möglichkeit zur Generierung komplett neuartiger Beschichtungseigenschaften, duale hochvernetzte Struktur kombiniert mit chemischer Oberflächenfunktion, z.B. der Polarität.

Insgesamt ergeben sich gegenüber bekannten und etablierten Verfahren folgende Vorteile:
- Der veränderte gleichzeitige Reaktionsablauf verhindert die separate Bildung anorganischer Cluster und die damit verbundene Phasentrennung vom organischen Netzwerk und führt zu homogenerer Netzwerkbildung mit dadurch verbesserten und über konventionelle Technik nicht erreichbaren Materialeigenschaften.
   ∘ Die dadurch erzielbaren Eigenschaften sind eine verbesserte mechanische Beständigkeit wie Kratz- und Abriebfestigkeit.
   ∘ Das vollständig ausgebildete organische Netzwerk bringt mehr elastische Eigenschaften ein, was insgesamt zu hartelastischen Schichten führt.
   ∘ Die erhöhte Netzwerkdichte verbessert die Barrierewirkung, die mechanische Stabilität (Kratzfestigkeit) und den Korrosionsschutz.
- Die variierbare Dosierung der einzelnen funktionellen Komponenten erleichtert eine Abstimmung der Haftungseigenschaften zum Substrat und eine gezielte Einstellung der Oberflächenchemie (Hydrophobie, Oleophobie) und ermöglicht den Aufbau von Gradientenschichten.
- Im Gegensatz zur bekannten Sol-Gel basierten Nasslacktechnik, ist das vorgeschlagene Verfahren einstufig (d.h. die erste Vernetzung bzw. Vorvernetzung, der Schichtauftrag und die zweite Vernetzung bzw. Endvernetzung bzw. Aushärtung erfolgen in einem einzigen Verfahrensschritt), was eine deutliche Prozessverkürzung mit einhergehender Energieeinsparung bedeutet. Gleichzeitig hat der Energieeintrag in der Beschichtungskammer eine deutlich höhere Reaktivität und Vernetzungsdichte der Komponenten zur Folge, die über konventionelle Schichthärtung in der Nasslackbeschichtungstechnologie nicht zu erzielen ist.
- Gegenüber herkömmlichen CVD-Verfahren kann das vorgeschlagene Verfahren auf eine deutlich größere Vielfalt an funktionellen (monomeren) Precursoren zurückgreifen, die aus der Technologie der Sol-Gel-basierten Nasslack-Hybridschichten bekannt sind und dort schon erfolgreich eingesetzt werden.
- Es können UV-härtende und im gleichen Prozess auch thermisch härtende Precursoren eingesetzt werden. Selbst bei Einsatz UV-härtender Precursoren kann auf die Zugabe von UV-Initiatoren verzichtet werden und dennoch eine vollständige Aushärtung erzielt werden.
- Somit ergibt sich bei den resultierenden funktionellen Schichten eine größere Bandbreite an Funktionalitäten und Kombinationen bei den Materialeigenschaften als bei den jeweiligen schon etablierten Verfahren.

Durch das separate Einbringen der Ausgangskomponenten in die Beschichtungskammer ist es möglich, dass die Komponenten über den Zufluss genau aufeinander abgestimmt werden können. So wird eine variable und im Prozess steuerbare Dosierung der einzelnen Komponenten und damit auch der Zusammensetzung der Beschichtung (z.B. Gradientenschicht) ermöglicht.

Insgesamt bietet sich für industrielle Anwendungen ein erhebliches Innovationspotential bei der Oberflächenveredelung.

Schritt c) des erfindungsgemäßen Verfahrens kann vorzugsweise bei Niederdruck (zum Beispiel PECVD-Prozess) oder bei Atmosphärendruck (zum Beispiel Flammpyrolyse) stattfinden.

Die Verfahrensbedingungen und die Precursorauswahl können so gestaltet werden, dass einerseits genügend Energie bereitgestellt wird, um die Polymerisations- und Vernetzungsreaktionen zu initiieren, und gleichzeitig die Unversehrtheit der funktionellen organischen Gruppen gewährleistet wird, um entsprechende Schichteigenschaften zu erzielen (z.B. Flexibilität, Elastizität, Hydrophobie). Für das Verfahren können geeignete funktionelle Ausgangskomponenten bereitgestellt und daraus für Plasma-CVD oder Flammpyrolyse einsetzbare und produktspezifische Beschichtungsmaterialien generiert werden. Die Ausgangsmaterialien für die Beschichtung (z.B. organisch modifizierte Metallalkoxide als typische Precursoren für Hybridschichten auch im bisherigen Sol-Gel-Prozess) können als gasförmige Komponenten ohne Lösemittel direkt in das Plasma oder als Aerosol in eine Flamme eingelassen und zur Reaktion gebracht werden. Es hat sich gezeigt, dass unter den gewählten Bedingungen die Unversehrtheit der organischen Komponenten zum weiteren Schichtaufbau gewährleistet werden kann.

Über die Zusammensetzung der Komponenten und die daraus abgeleitete anorganische und organische Netzwerkstruktur in Kombination mit organisch reaktiven und funktionellen Gruppen laufen unter den gewählten Bedingungen Polymerisationsprozesse ab, aus denen neue bisher nicht erreichte innovative Komponenten- sowie Strukturkombinationen und Materialeigenschaften resultieren (z.B. dual hochvernetzte Strukturen für Korrosionsschutz, Kratzfestigkeit, Hartelastizität, Gradientenschichten, spezielle Grenzflächenchemie).

Vorzugsweise wird in Schritt c) ein Plasma-unterstützter oder pyrolytisch unterstützter chemischer Gasphasenabscheidungs-Prozess in der Beschichtungskammer durchgeführt, bei welchem sowohl die in die Beschichtungskammer eingebrachten Ausgangskomponenten zu mindestens einer vernetzbaren Vorstufe des mindestens einen anorganisch-organischen Hybridpolymers umgesetzt werden als auch die mindestens eine vernetzbare Vorstufe auf mindestens einer Oberfläche eines Substrats abgeschieden und zum mindestens einen anorganisch-organischen Hybridpolymer vernetzt wird.

Vorzugsweise werden bei dem Plasma-unterstützten oder pyrolytisch unterstützten chemischen Gasphasenabscheidung-Prozess in Schritt c)
- die in die Beschichtungskammer eingebrachten Ausgangskomponenten zu mindestens einer vernetzbaren Vorstufe des mindestens einen anorganisch-organischen Hybridpolymers umgesetzt,
- die mindestens eine vernetzbare Vorstufe zum mindestens einen anorganisch-organischen Hybridpolymer vernetzt, und
- die mindestens eine vernetzbare Vorstufe des mindestens einen anorganisch-organischen Hybridpolymers und/oder das mindestens eine anorganisch-organische Hybridpolymer auf mindestens einer Oberfläche eines Substrats abgeschieden.

Vorzugsweise handelt es sich bei den verschiedenen Ausgangskomponenten (bzw. Ausgangsverbindungen bzw. Precursoren) für mindestens ein anorganisch-organisches Hybridpolymer um verschiedene monomere Ausgangskomponenten (bzw. monomere Ausgangsverbindungen bzw. monomere Precursor) für mindestens ein anorganisch-organisches Hybridpolymer.

Eine bevorzugte Variante des erfindungsgemäßen Verfahrens zeichnet sich dadurch aus, dass die verschiedenen (monomeren) Ausgangskomponenten ausgewählt sind aus der Gruppe bestehend aus organisch modifizierten Metallalkoxiden, organisch modifizierten Silicaten, organisch modifizierten Silanen, organische modifizierten Siloxanen, und Kombinationen hiervon.

Vorzugsweise weisen die organisch modifizierten Silane (jeweils) mindestens eine Si-O-Bindung auf, besonders bevorzugt an jedem Silicium-Atom.

Gemäß einer besonders bevorzugten Variante des erfindungsgemäßen Verfahrens
- sind die verschiedenen (monomeren) Ausgangskomponenten ausgewählt aus mindestens einer Komponente A, mindestens einer Komponente B, mindestens einer Komponente C, und Kombinationen hiervon, oder
- umfassen die verschiedenen (monomeren) Ausgangskomponenten mindestens eine Komponente A, mindestens eine Komponente B, mindestens eine Komponente C, und optional mindestens ein Epoxypolymer oder bestehen daraus,

wobei die mindestens eine Komponente A ausgewählt ist aus der Gruppe bestehend aus Metallalkoholaten, die peralkoxyliert sein können oder mindestens einen ein- oder zweizähnigen Liganden aufweisen können, Tetraalkylorthosilicaten, Hexaalkyldisilicaten, Octaalkyltrisilicaten, Decaalkyltetrasilicaten, Dodecaalkylpentasilicaten und Mischungen hiervon,
wobei die mindestens eine Komponente B ausgewählt ist aus Verbindungen gemäß der folgenden Formeln (B-I) bis (B-V) 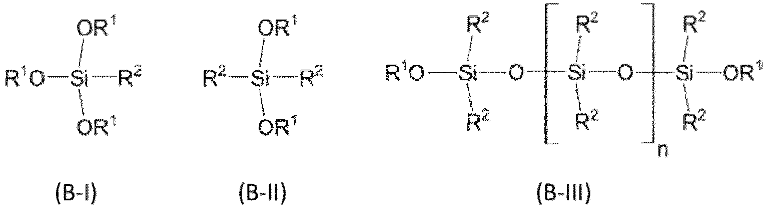 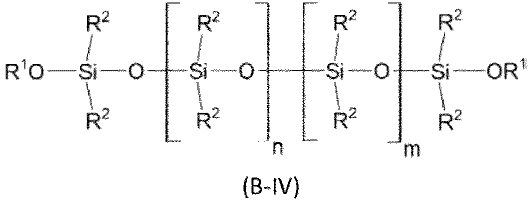 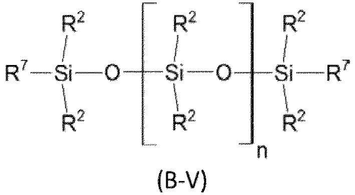
und Mischungen aus diesen Verbindungen,
wobei die mindestens eine Komponente C ausgewählt ist aus Verbindungen gemäß den folgenden Formeln (C-I) bis (C-III), 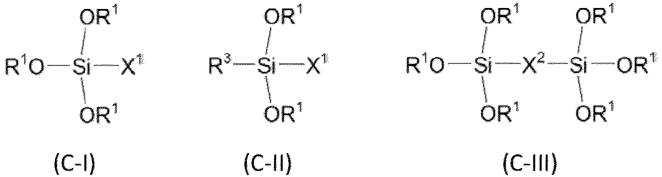
und Mischungen aus diesen Verbindungen,
wobei
   - R¹: bei jedem Auftreten gleich oder verschieden ist und ausgewählt ist aus der Gruppe bestehend aus Wasserstoff, Methyl, Ethyl, n-Propyl, *iso-*Propyl, n-Butyl, iso-Butyl, sec-Butyl und tert-Butyl,
   - R²: bei jedem Auftreten gleich oder verschieden ist und ein Rest ist, der ausgewählt ist aus der Gruppe bestehend aus Alkyl-Resten, welche einfach, mehrfach, vollständig oder nicht halogeniert sein können, Aryl-Resten, welche einfach, mehrfach, vollständig oder nicht halogeniert sein können, Arylalkyl-Resten, welche einfach, mehrfach, vollständig oder nicht halogeniert sein können, Alkylaryl-Resten, welche einfach, mehrfach, vollständig oder nicht halogeniert sein können, Aminoalkyl-Resten und Mercaptoalkyl-Resten, wobei der Rest in allen Fällen an einer oder mehreren Stellen durch eine oder mehrere Gruppierungen unterbrochen sein kann, die ausgewählt sind aus der Gruppe bestehend aus O, S, NR¹, NR¹₂⁺Cl⁻, NR¹2+CH₃COO⁻, C(O), C(O)O, C(O)OC(O), C(O)NR¹, NR¹C(O), NR¹C(O)NR¹ und Kombinationen hiervon,
   - R³: ausgewählt ist aus der Gruppe bestehend aus Methyl, Ethyl, n-Propyl, iso-Propyl, n-Butyl, iso-Butyl, sec-Butyl und tert-Butyl,
   - R⁷: bei jedem Auftreten gleich oder verschieden ist und ein Trialkoxysilylalkyl-Rest ist, welcher an einer oder mehreren Stellen durch eine oder mehrere Gruppierungen unterbrochen sein kann, die ausgewählt sind aus der Gruppe bestehend aus NR₁, C(O), C(O)NR¹, NR¹C(O), NR¹C(O)NR¹ und Kombinationen hiervon,
   - X¹: bei jedem Auftreten gleich oder verschieden ist und ein Rest ist, der mindestens eine C=C-Doppelbindung und/oder mindestens eine Epoxid-Gruppe aufweist,
   - X²: eine verbrückende Gruppierung ist, die mindestens eine C=C-Doppelbindung und/oder mindestens eine Epoxid-Gruppe aufweist,
   - m: eine Zahl von 0 bis 25 ist, und
   - n: eine Zahl von 0 bis 25 ist.

Vorzugsweise sind die Metallalkoholate der Komponente A ausgewählt aus Metallalkoholaten gemäß einer der folgenden Formeln (A-I) bis (A-IV) 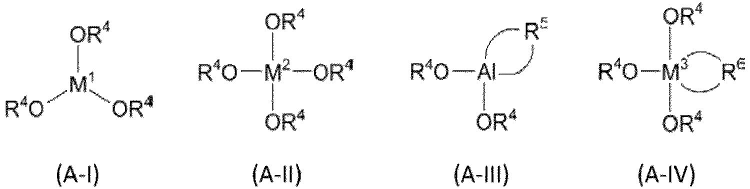 wobei
- M¹: ausgewählt ist aus der Gruppe bestehend aus dreiwertigen Hauptgruppenelementen und dreiwertigen Übergangsmetallen, wobei M¹ vorzugsweise Al ist,
- M²: ausgewählt ist aus der Gruppe bestehend aus Ti und Zr,
- M³: ausgewählt ist aus der Gruppe bestehend aus Al, Ti und Zr,
- R⁴: bei jedem Auftreten gleich oder verschieden ist und ausgewählt ist aus der Gruppe bestehend aus Methyl, Ethyl, n-Propyl, iso-Propyl, n-Butyl, iso-Butyl, sec-Butyl und tert-Butyl,
- R⁵: ein Chelatligand ist, der über zwei O-Atome an Al gebunden ist, wobei der Chelatligand vorzugsweise Acetylaceton oder Acetessigsäureethylester ist,
- R⁶: eine organische Säure mit mindestens einer Carboxylgruppe ist, welche über beide O-Atome einer ihrer Carboxylgruppen an M³ gebunden ist, wobei die organische Säure vorzugsweise ausgewählt ist aus der Gruppe bestehend aus Essigsäure, Propionsäure, Methacrylsäure, Acrylsäure, Benzoesäure und Milchsäure.

Besonders bevorzugt ist die mindestens eine Komponente A ausgewählt aus den folgenden Verbindungen A1 bis A8, 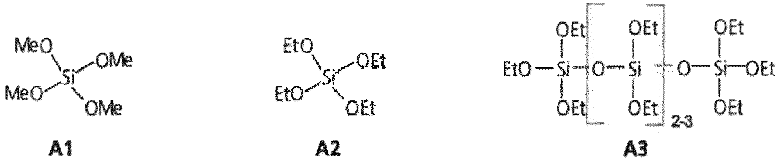 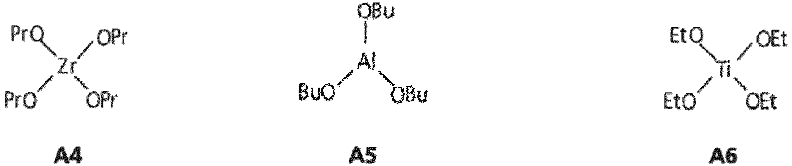 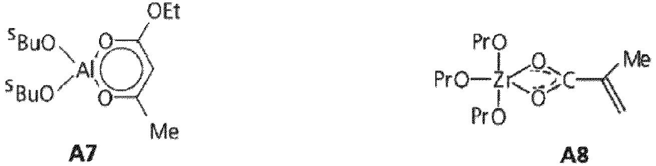 und Mischungen aus diesen Verbindungen.

Der Rest ^{S}Bu bedeutet hierbei sec-Bu (d.h. sec-Butyl).

Vorzugsweise ist die mindestens eine Komponente B ausgewählt ist aus den folgenden Verbindungen B1 bis B15 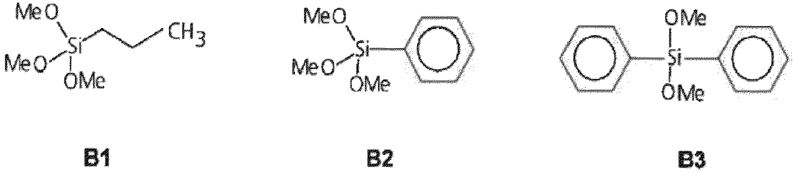 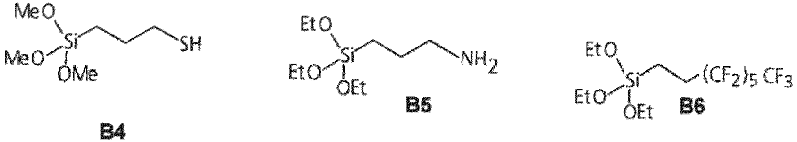 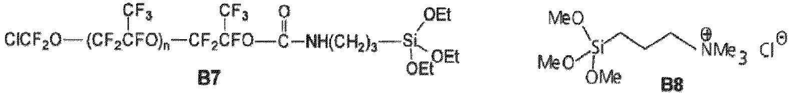 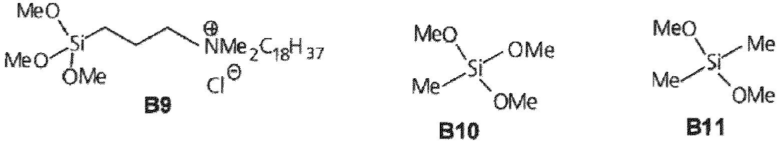 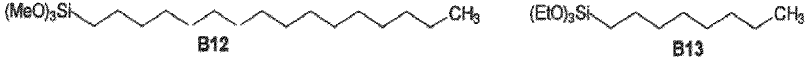 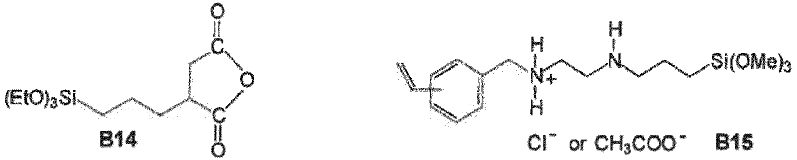 und Mischungen aus diesen Verbindungen. Die Variable n ist eine Zahl von 0 bis 25, vorzugsweise von 1 bis 25.

Vorzugsweise ist die mindestens eine Komponente C ausgewählt aus den folgenden Verbindungen C1 bis C20 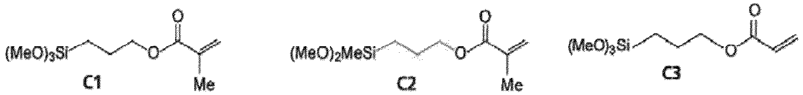 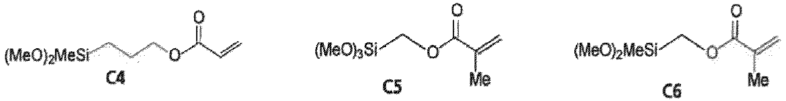 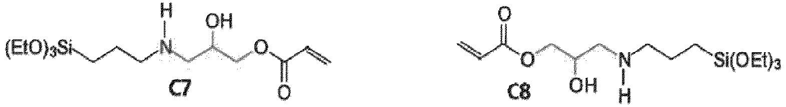 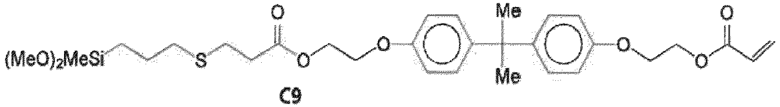 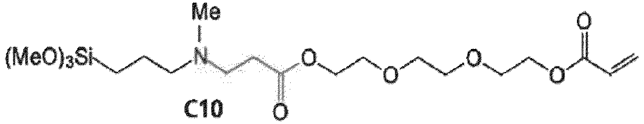 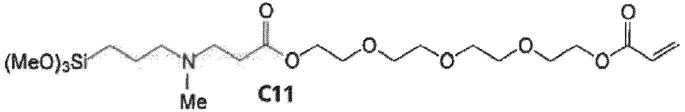 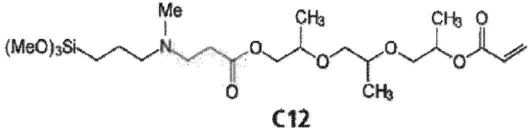 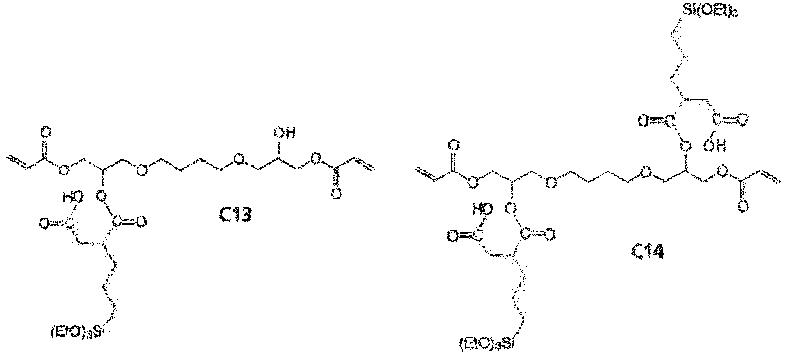 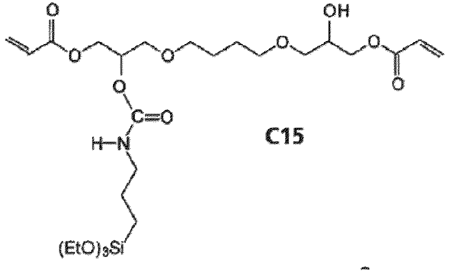 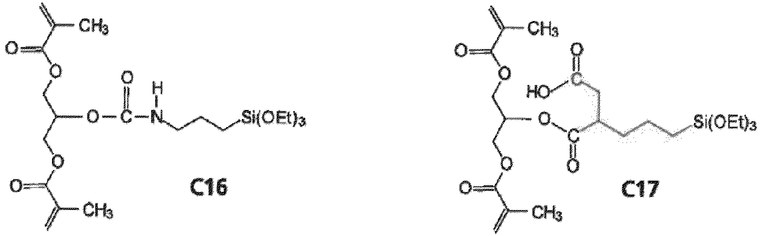 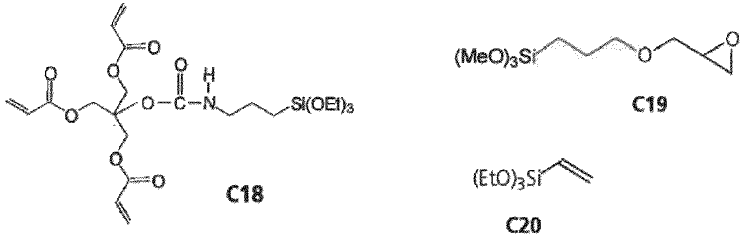 und Mischungen aus diesen Verbindungen.

Beispielsweise sind die (monomeren) Ausgangskomponenten ausgewählt aus der Gruppe bestehende aus (3-Glycidyloxypropyl)trimethoxysilan, Tetraethylorthosilicat bzw. Tetraethoxysilan, 3-(Trimethoxysilyl)propylmethacrylat, Vinyltriethoxysilan, Methyltrimethoxysilan, Trimethoxy(propyl)silan, (3-Aminopropyl)triethoxysilan, (3-Mercaptopropyl)trimethoxysilan bzw. 3-Trimethoxysilylpropane-1-thiol, 1H,1H,2H,2H-Perfluorooctyltriethoxysilan bzw. 1H,1H,2H,2H-Tridecafluoro-n-octyltriethoxysilan, und Kombinationen hiervon.

Eine weitere bevorzugte Variante des erfindungsgemäßen Verfahrens ist dadurch gekennzeichnet, dass das Substrat
- ein Material enthält oder daraus besteht, welches ausgewählt ist aus der Gruppe bestehend aus Gläsern; Kunststoffen, vorzugsweise künstlichen Kunststoffen, natürlichen Kunststoffen, biobasierten Kunststoffen; Metallen; faserbasierten Materialien, vorzugsweise Papier; und Kombinationen hiervon, und/oder
- textiles Substrat ist.

Beispielsweise kann als Substrat ein PMMA-Substrat verwendet werden.

Eine weitere bevorzugte Variante des erfindungsgemäßen Verfahrens zeichnet sich dadurch aus, dass
- die Beschichtungskammer Wasser enthält oder während Schritt c) Wasser in die Beschichtungskammer eingebracht wird, und/oder
- die Beschichtungskammer Sauerstoff enthält oder während Schritt c) Sauerstoff in die Beschichtungskammer eingebracht wird.

Gemäß einer weiteren bevorzugten Variante des erfindungsgemäßen Verfahrens werden die verdampften oder vernebelten (monomeren) Ausgangskomponenten in Schritt b) ohne Lösungsmittel in die Beschichtungskammer eingebracht.

Eine weitere bevorzugte Variante des erfindungsgemäßen Verfahrens ist dadurch gekennzeichnet, dass in Schritt c)

in einem ersten Teilprozess eine anorganische Vernetzung der (monomeren) Ausgangskomponenten zur mindestens einen vernetzbaren Vorstufe initiiert wird, vorzugweise durch Sauerstoff, wobei gleichzeitig (durch reaktive Plasmakomponenten oder durch reaktive pyrolytische Komponenten) eine weitere organische Vernetzung der mindestens einen vernetzbaren Vorstufe zum mindestens einen anorganisch-organischen Hybridpolymer erfolgt,

in einem zweiten Teilprozess eine Sol-Gel-Reaktion durch Wasser initiiert wird, wobei gleichzeitig die weitere organische Vernetzung der mindestens einen vernetzbaren Vorstufe zum mindestens einen anorganisch-organischen Hybridpolymer erfolgt, und

in einem dritten Teilprozess die mindestens eine vernetzbare Vorstufe und das mindestens eine anorganisch-organische Hybridpolymer durch Plasmaunterstützung oder pyrolytische Unterstützung zu mindestens einer anorganisch-organischen Hybridpolymer-Beschichtung auf der mindestens einen Oberfläche des Substrats abgeschieden werden.

Eine bevorzugte Variante des erfindungsgemäßen Verfahrens zeichnet sich dadurch aus, dass zur Durchführung des Plasma-unterstützten chemischen Gasphasenabscheidungs-Prozesses ein Plasma erzeugt wird, indem mindestens ein Plasmagas, vorzugsweise Argon und/oder Stickstoff, durch eine Hochfrequenzentladung ionisiert wird, wobei die Hochfrequenzentladung vorzugsweise durch eine Metallelektrode erfolgt, die eine Durchbohrung aufweist, durch welche das mindestens eine Plasmagas in die Beschichtungskammer eingeleitet wird.

Eine weitere bevorzugte Variante des erfindungsgemäßen Verfahrens ist dadurch gekennzeichnet, dass der Plasma-unterstützte chemische Gasphasenabscheidungs-Prozess
- bei einem Druck von 0,1 Pa bis 100 Pa, bevorzugt von 1 Pa bis 10 Pa, und/oder
- bei einer Leistung von 0,005 W/cm² bis 0,5 W/cm², bevorzugt von 0,02 W/cm² bis 0,2 W/cm², und/oder
- für eine Dauer von 1 min bis 100 min, bevorzugt von 10 min bis 50 min, durchgeführt wird.

Eine weitere bevorzugte Variante des erfindungsgemäßen Verfahrens ist dadurch gekennzeichnet, dass der pyrolytisch unterstützte chemische Gasphasenabscheidungs-Prozess
- bei Atmosphärendruck, und/oder
- für eine Dauer von 1 min bis 100 min, bevorzugt von 5 min bis 50 min, und/oder
- bei einer Temperatur in einem Bereich von -10 °C bis 100 °C,
durchgeführt wird.

Gemäß einer weiteren bevorzugten Variante des erfindungsgemäßen Verfahrens werden keine UV-Initiatoren verwendet.

Verfahren gemäß einem der vorhergehenden Ansprüche, dadurch gekennzeichnet, dass Schritt a) unter Verwendung eines mehrkanaligen Verdampfersystems oder eines mehrkanaligen Vernebelungssystems durchgeführt wird, welches vorzugsweise Temperaturen bis zu 250 °C ermöglicht.

Eine bevorzugte Variante des erfindungsgemäßen Verfahrens zeichnet sich dadurch aus, dass in Schritt b) die verdampften oder vernebelten (monomeren) Ausgangskomponenten durch separate Gaseinlässe, bevorzugt separate Gasduschen, in die Beschichtungskammer eingebracht werden, wobei sich die separaten Gaseinlässe vorzugsweise in der Nähe des Substrats befinden.

Eine weitere bevorzugte Variante des erfindungsgemäßen Verfahrens ist dadurch gekennzeichnet, dass
- die Beschichtungskammer auf einer Temperatur in einem Bereich von 50 °C bis 100 °C, bevorzugt von 60 °C bis 80 °C, gehalten wird, und/oder
- die verdampften oder vernebelten (monomeren) Ausgangskomponenten zwischen Schritt a) und Schritt b) über Rohrleitungen zur Beschichtungskammer transportiert werden, wobei die Rohrleitungen auf einer Temperatur im Bereich von 45 °C bis 95 °C, bevorzugt von 55 °C bis 75 °C, gehalten werden.

Die vorliegende Erfindung betrifft zudem auch ein beschichtetes Substrat, umfassend ein Substrat mit mindestens einer anorganisch-organischen Hybridpolymer-Beschichtung, wobei die Beschichtung bzw. das beschichtete Substrat mit dem erfindungsgemäßen Verfahren herstellbar oder hergestellt ist.

Eine bevorzugte Ausführungsform des erfindungsgemäßen beschichteten Substrats zeichnet sich dadurch aus, dass die mindestens eine anorganisch-organischen Hybridpolymer-Beschichtung
- eine Schichtdicke von 0,1 bis 10 µm, bevorzugt von 0,5 bis 1,0 µm, und/oder
- einen Kontaktwinkel (H₂O) von 70° bis 120°, bevorzugt von 80° bis 110°, aufweist, und/oder
- ein Fluor-/Silicium-Verhältnis von 5,0 bis 15,0, bevorzugt von 7,0 bis 13,0,
aufweist.

Die Schichtdicke kann beispielsweise bestimmt werden mittels Profilometer an einer Schichtkante nach DIN 50933:2015 oder DIN EN ISO 4518:2021.

Der Kontaktwinkel (H₂O) kann beispielsweise bestimmt werden mittels DIN EN ISO 19403-2:2020.

Das Fluor-/Silicium-Verhältnis kann beispielsweise bestimmt werden mittels EDX-Elementanalyse.

Hybridpolymere Schichtmaterialien werden bisher im weit verbreiteten Sol-Gel-Verfahren hergestellt und nasschemisch verarbeitet. Dabei wird in Lösung zunächst ein anorganisches Grundgerüst aufgebaut, das nach dem Schichtauftrag über eingebaute Reaktivgruppen durch organische Polymerisation quervernetzt wird. Dieses zweistufige Verfahren beinhaltet eine Einschränkung sowohl bei der in Lösung langsam stattfindenden anorganischen Netzwerkbildung als auch bei der im Nassfilm initiierten organischen Polymerisation, da die im ersten Schritt gebildeten anorganischen Strukturen eine komplette organische Polymerisation sterisch behindern können.

Die in der vorliegenden Erfindung vorgesehene Herstellung der Hybridschichten vermeidet diese strukturellen Nachteile dadurch, dass die Reaktion zum anorganischen Netzwerk und die organische Polymerisation zum Hybridnetzwerk gleichzeitig initiiert werden und in einer Gasphase ablaufen. Insgesamt ergeben sich dadurch folgende material- und eigenschaftsrelevante Vorteile:
- Ein homogener Aufbau der anorganischen und organischen polymeren Strukturkomponenten, unter Vermeidung von anorganischen Clustern, die eine Phasenseparation begünstigen und die organische Netzwerkbildung behindern. Ein homogenes duales Netzwerk führt zu günstigeren mechanischen Eigenschaften, die z.B. in hartelastischen Schichten resultieren oder die dichtere Netzwerkbildung ermöglicht Barriereeigenschaften und dadurch verbesserten Korrosionsschutz.
- Einsatz eines Einstufenprozesses und Vermeidung des 3-teiligen Prozesses bestehend aus Sol-Gel-Synthese, Schichtauftrag und Schichthärtung durch organische Quervernetzung/Polymerisation.
- Durch selektive und variierte Precursordosierung ist ein gezielter Gradientenaufbau möglich mit substrat- und haftungsspezifischen Komponenten im unteren Grenzflächenbereich und mit chemisch- oder mechanisch funktionellen Strukturen oder Materialkomponenten im oberflächennahen Bereich.
- Durch Verzicht auf UV-Initiatoren und Vermeidung des Einbaus von deren Rückständen innerhalb der Schichten ist eine höhere Stabilität der ausgehärteten Schichten und die Vermeidung von bedenklichen rückständigen Schadstoffen möglich.

Es eröffnen sich somit Möglichkeiten zur Erzeugung neuer, multifunktioneller Beschichtungen, z.B. mit hoher Kratzfestigkeit, Diffusionsbarriere, Korrosionsschutz durch ungehinderte duale und somit dichte Netzwerkbildung und Erzielung von hartelastischen Eigenschaften durch die anorganischen und organischen Polymerstrukturen.

Die Besonderheit dieses neuen Konzepts liegt darin, dass der bisher bei nasschemischen hybriden Sol-Gel basierten Schichten örtlich und zeitlich voneinander getrennt stattfindende Aufbau anorganischer und organischer vernetzter Struktureinheiten zeitgleich ablaufen. Die Begrenzung des Reaktionsvolumens sowie die gezielte Materialdosierung ermöglicht eine Minimierung des notwendigen Energie-, Zeit- und Materialaufwands, zum Beispiel Overspray. Zudem kann auf den Einsatz von Lösemitteln vollständig verzichtet werden.

Die moderne Oberflächentechnik hat sich zu einer der wichtigsten Schlüsselindustrien mit zunehmender volkswirtschaftlicher und ökologischer Bedeutung entwickelt hat. Die Oberflächentechnologie ist eine interdisziplinäre Schlüssel- und Querschnittstechnologie, deren Anwendung für immer mehr Branchen durch innovative Produkt- und Verfahrensverbesserungen zum Schlüssel des Erfolgs wird.

Als zentrale Zukunftsthemen stehen die Beherrschung der Komplexität der Beschichtung und der Beschichtungsprozesse sowie die Notwendigkeit der Entwicklung komplexer Eigenschaftsprofile von Schichten an erster Stelle.

Die Bereitstellung funktionaler Schichten mit verbessertem Verschleiß- und Korrosionsschutz gewinnt zunehmend an Bedeutung für Anwendungen in den Bereichen Optik, Automobil, Geräte- und Maschinenbau und für viele Belange von Arbeitsplatz und Wohnraum. Es ist aus den Produkten und Umsetzungen der derzeitigen Technologie zur Herstellung hybrider Schichten über herkömmliche Nasslackverfahren abzusehen, dass diese allein nicht die gesamte Breite der Anforderungen in den unterschiedlichen Branchen abdecken kann. Durch die Anwendung der Plasmatechnologie bei sonst nur nasschemisch verarbeitbaren hybriden Schichten werden die Stärken zweier Verfahrenstechniken zusammengeführt und Möglichkeiten für Zukunftsmärkte geschaffen.

Die Plasmatechnologie als Verarbeitungs- und Abscheidemethode von hybriden Schichten ist noch nicht Stand der Technik, obwohl hybride Schichten über nasschemische Sol-Gel-Verfahren einerseits und auf Basis einfachster Precursorverbindungen im Plasma andererseits, für unterschiedliche Anwendungen am Markt bereits eingesetzt werden. Durch den Einsatz der beschriebenen Methode erweitert sich somit das Anwendungsspektrum des Beschichtungsmaterials, andererseits werden bei optimaler Ausnutzung aller Kapazitäten des Verfahrens die inhärent guten Materialeigenschaften noch besser zur Geltung kommen. Dies ermöglicht den Übertrag auf Anwendungsgebiete, die den Schichtsystemen bisher verschlossen blieben.

Die vorliegende Erfindung wird anhand der nachfolgenden Figuren und Beispiele näher erläutert, ohne die Erfindung auf die speziell dargestellten Parameter zu beschränken.

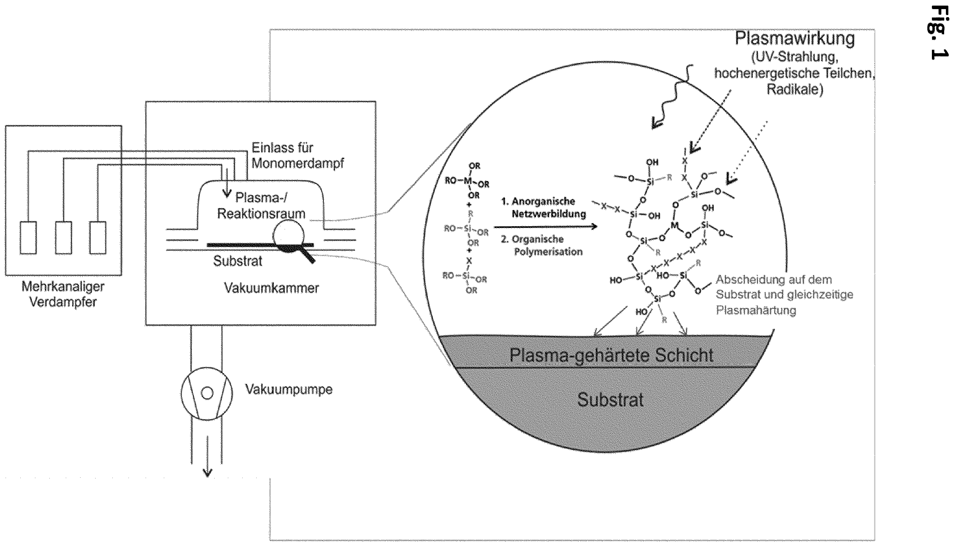

Fig. 1 zeigt links eine beispielhafte schematische Darstellung des kombinierten Beschichtungsprozesses im Niederdruck-Plasma. Die Monomere werden lösungsmittelfrei verdampft und separat dem Plasmaprozess zugeführt. Der Prozessraum wird durch Abschirmungen auf einen Teil der Beschichtungskammer beschränkt. Schmale Pumpspalte sorgen für Druckentkopplung des Prozessraumes und Schutz der Vakuumpumpen. Fig. 1 zeigt rechts eine Prinzipdarstellung der ablaufenden Prozesse beim Beschichtungsprozess. Die Monomere reagieren in der Gasphase (zusätzlich stimuliert durch das Plasma) zum Präpolymer, das sich auf dem Substrat abscheidet und durch Plasmawirkung aushärtet.

### Ausführungsbeispiele

Da aufgrund der geringen Schichtdicke bisheriger abgeschiedener Schichten keine aussagekräftigen Charakterisierungen zu den Funktionseigenschaften der Schichten durchgeführt werden konnten, wurden mittels deutlich erhöhter Abscheidedauer Schichten auf Basis von MPTMO/VTEO (siehe Tabelle 1) mit höherer Schichtdicke hergestellt.

**Tabelle 1. Ausgewählte Precursorkomponenten**

| **Abkürzung** | **ISC-Kürzel** | **Verwendete chemische Bezeichnungen und Katalogbezeichnungen** | **Chemische Formel** |
|---|---|---|---|
| **GLYMO** | G | (3-Glycidyloxypropyl)trimethoxysilan | 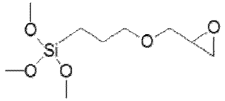 |
| **TEOS** | Oe | Tetraethylorthosilicat Tetraethoxysilan | 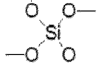 |
| **MEMO** | M | 3-(Trimethoxysilyl)propylmethacrylat Dynasylan^{®} MEMO | 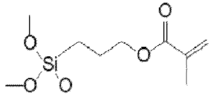 |
| **VTEO** | V | Vinyltriethoxysilan | 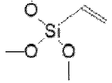 |
| **MTMO** | T | Methyltrimethoxysilan | 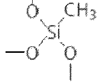 |
| **PTMO** | P | Trimethoxy(propyl)silan | 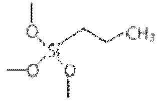 |
| **AMEO** | A | (3-Aminopropyl)triethoxysilan | 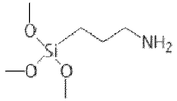 |
| **MPTMO** | Mc | (3-Mercaptopropyl)trimethoxysilan Dynasylan^{®} MTMO 3-Trimethoxysilylpropane-1-thiol | 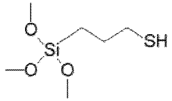 |
| **F13** | F | 1H,1H,2H,2H-Perfluorooctyltriethoxysilane | 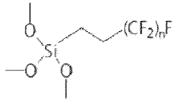 |
| | | Dynasylan^{®} F 8261 | |
| | | 1H,1H,2H,2H-Tridecafluoro-n-octyltriethoxysilane | |

Dieser Schichttyp wird seit langem als UV-härtende Sol-Gel basierte Kratzschutzschicht für PMMA eingesetzt. Die Reaktivkomponenten vernetzen dabei das vorgebildete anorganische Netzwerk über eine UV-induzierte Vinyl-/Mercapto-Addition:

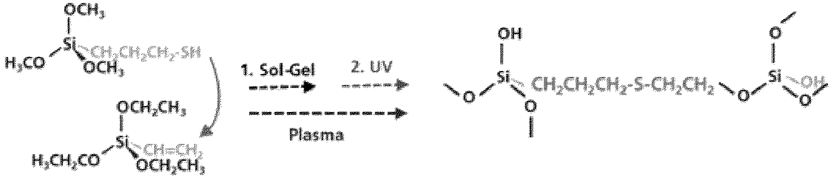

Dabei wurden für die Beschichtungen Niederdruck-Plasmaprozesse eingesetzt. Eine solche Beschichtungsanlage kann z.B. aus einer Beschichtungskammer bestehen, die mit Drehschieberpumpen auf ein Grobvakuum im Bereich von 1 bis 10 Pa evakuiert wird. Ein metallischer Substrathalter wird waagerecht in der Reaktorkammer platziert und elektrisch geerdet, d.h. durch eine elektrisch leitfähige Verbindung mit Erdpotential verbunden. Über dem Substrat befindet sich eine Metallelektrode, die mit einer Hochspannung, z.B. in Hochfrequenz (16,4 GHz) beaufschlagt wird.

Diese Metallelektrode ist durchbohrt, was die Einleitung eines Plasmagases wie z.B. Ar oder N₂ durch die Elektrode ermöglicht, mit dem Vorteil, dass diese Plasmagase durch die Hochfrequenzentladung ionisiert werden. Damit wird erreicht, dass die Elektrode von einem hochdichten Plasma geringer bis mittlerer Energie aus neutralem Gas umgeben ist und dass dieser Bereich keine oder nur eine geringe Konzentration an chemischen Precursorkomponenten enthält. So können Ablagerungen auf der Elektrode vermieden werden. Zwischen der Metallelektrode und dem Substrathalter, vorzugsweise in der Nähe des Substrathalters befinden sich zwei (oder mehr) separate Gaseinlässe, z.B. Gasduschen mit jeweils mehreren Öffnungen, durch die Gase in die Beschichtungskammer eingeleitet werden können. Diese Gaseinlässe ermöglichen die Einleitung der chemischen Precursorkomponenten in das Plasma örtlich getrennt von dem Bereich mit dem hochdichten Plasma vor der Metallelektrode. Aber auch am Ort des Gaseinlasses sind Radikale und aktive Spezies vorhanden, die Reaktionen zwischen den beiden (oder mehreren) hochreaktiven chemischen Precursorkomponenten einleiten. Unabhängige und separate Gasduschen haben den Vorteil, jeden Kontakt und jede Reaktion zwischen den chemischen Precursorkomponenten zu vermeiden, bis sie sich in der Nähe des Beschichtungsbereichs befinden.

Die chemischen Precursorkomponenten werden in dichten Behältern aufbewahrt, die auf Verdampfungstemperatur (z.B. 60 °C) gehalten werden. Die verdampften Ausgangsstoffe werden entweder durch einfaches Ansaugen aus dem Vakuum oder durch einen zusätzlichen Trägergasstrom zu den Gaseinlässen transportiert. Die Rohrleitungen vom Verdampfer zur Beschichtungskammer wird auf einer erhöhten Temperatur gehalten, um jegliches Risiko einer Rekondensation zu vermeiden (z. B. 65 °C). Die Beschichtungskammer selbst wird aus demselben Grund auf einer noch höheren Temperatur (z.B. 70°C) gehalten, wobei darauf geachtet wird, dass Temperaturinhomogenitäten (heiße Punkte, kalte Punkte) vermieden werden.

Sowohl die Temperaturen im Verdampfer, als auch die in den Rohrleitungen und die in der Beschichtungskammer werden weit unterhalb der Reaktionstemperatur für die spontane Polymerisation der einzelnen chemischen Precursorkomponenten eingestellt.

Auf diese Weise können Schichten auf unterschiedlichen Substraten hergestellt werden, auch auf Kunststoff wie z.B. PMMA.

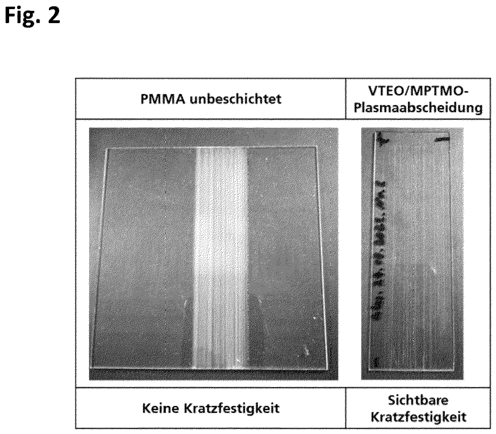

Zur Prüfung der Kratzfestfunktion wurde eine ca. 2,1 µm dicke Schicht auf Glas innerhalb von ca. 30 min abgeschieden und einem Kratztest unterzogen (siehe Fig. 2).

Das Ergebnis ist wie folgt:
- Unbeschichtetes PMMA (Fig. 2, links) hat eine sehr hohe Kratzempfindlichkeit und zeigt deutliche Kratzspuren.
- Die Plasma-abgeschiedene MPTMO/VTEO Schicht (Fig. 2, rechts) hat eine deutlich reduzierte Kratzempfindlichkeit im Vergleich zu unbeschichtetem PMMA.

Selbst eine lange Abscheidedauer über 30 min oder mehr stellt einen klaren Zeitvorteil dar gegenüber der mehrstündigen Sol-Gel Synthese gefolgt vom Beschichtungs- und Schichthärtungsvorgang.

In einem abschließenden Versuch wurde das funktionelle Fluoralkylsilan F13 (siehe Tabelle 2) unter unterschiedlichen Bedingungen auf Si-Wafern und Glasobjektträgern abgeschieden und die erhaltenen Schichten charakterisiert. Diese funktionelle Komponente ist Bestandteil vieler Schichtvarianten mit Antihaft- oder easy-to-clean Eigenschaften. Hierbei wurden in Abhängigkeit von den Abscheideraten sowohl unterschiedliche Schichtdicken als auch unterschiedliches Verhalten gegenüber der Benetzung mit Wasser gefunden. Die durch die Fluoralkylgruppe erzeugte Hydrophobie wurde durch Kontaktwinkelmessung bestätigt. Die EDX-Elementanalyse des gefundenen Fluor- und Siliciumanteils bestätigten die Abscheidung eines Fluoralkylhaltigen Silans (siehe Tabelle 2).

**Tabelle 2. Charakterisierung von plasmaabgeschiedene Fluoralkylsilanschichten**

| **Abscheideparameter FEP** | | **Schichtdicke [µm]** | **Kontaktwinkel H₂O** | **F/Si gefunden** | **F/Si berechnet** |
|---|---|---|---|---|---|
| #1 | 0,06 W/cm², 50 Pa, 30 min | 0,55-0,64 | 99°-100° | 11,8-12,1 | 13 |
| #2 | 0,07 W/cm², 50 Pa, 30 min | 0,85-0,92 | 101°-103° | 9,4-11,1 | |
| #3 | 0,14 W/cm², 50 Pa, 20 min | 0,52-0,64 | 83°- 88° | 8,7-10,1 | |

Insgesamt konnte festgestellt werden, dass mit 30 min Abscheidedauer eine Schicht mit den gewünschten Schichteigenschaften abgeschieden werden konnte. Das gefundene F/Si-Verhältnis entspricht nahezu dem theoretisch möglichen Wert und deutet somit ebenfalls auf die Abscheidung des funktionellen Precursors hin.

## Patentansprüche

1. Verfahren zur Herstellung anorganisch-organischer Hybridpolymer-Beschichtungen, bei welchem
a) verschiedene Ausgangskomponenten für mindestens ein anorganisch-organisches Hybridpolymer verdampft oder vernebelt werden,
b) die verdampften oder vernebelten Ausgangskomponenten separat voneinander in eine Beschichtungskammer eingebracht werden, und
c) ein Plasma-unterstützter oder pyrolytisch unterstützter chemischer Gasphasenabscheidung-Prozess in der Beschichtungskammer durchgeführt wird, bei welchem mindestens eine anorganisch-organische Hybridpolymerbeschichtung erhalten wird, indem
- die in die Beschichtungskammer eingebrachten Ausgangskomponenten zu mindestens einer vernetzbaren Vorstufe des mindestens einen anorganisch-organischen Hybridpolymers umgesetzt werden,
- die mindestens eine vernetzbare Vorstufe zum mindestens einen anorganisch-organischen Hybridpolymer vernetzt wird, und
- die in die Beschichtungskammer eingebrachten Ausgangskomponenten, die mindestens eine vernetzbare Vorstufe des mindestens einen anorganisch-organischen Hybridpolymers und/oder das mindestens eine anorganisch-organische Hybridpolymer auf mindestens einer Oberfläche eines Substrats abgeschieden wird/werden.

2. Verfahren gemäß dem vorhergehenden Anspruch, **dadurch gekennzeichnet, dass** die verschiedenen Ausgangskomponenten ausgewählt sind aus der Gruppe bestehend aus organisch modifizierten Metallalkoxiden, organisch modifizierten Silicaten, organisch modifizierten Silanen, organische modifizierten Siloxanen, und Kombinationen hiervon.

3. Verfahren gemäß einem der vorhergehenden Ansprüche, **dadurch gekennzeichnet, dass** das Substrat
- ein Material enthält oder daraus besteht, welches ausgewählt ist aus der Gruppe bestehend aus Gläsern; Kunststoffen, vorzugsweise künstlichen Kunststoffen, natürlichen Kunststoffen, biobasierten Kunststoffen; Metallen; faserbasierten Materialien, vorzugsweise Papier; und Kombinationen hiervon, und/oder
- ein textiles Substrat ist.

4. Verfahren gemäß einem der vorhergehenden Ansprüche, **dadurch gekennzeichnet, dass**
- die Beschichtungskammer Wasser enthält oder während Schritt c) Wasser in die Beschichtungskammer eingebracht wird, und/oder
- die Beschichtungskammer Sauerstoff enthält oder während Schritt c) Sauerstoff in die Beschichtungskammer eingebracht wird.

5. Verfahren gemäß einem der vorhergehenden Ansprüche, **dadurch gekennzeichnet, dass** die verdampften oder vernebelten Ausgangskomponenten in Schritt b) ohne Lösungsmittel in die Beschichtungskammer eingebracht werden.

6. Verfahren gemäß einem der vorhergehenden Ansprüche, **dadurch gekennzeichnet, dass** in Schritt c)
in einem ersten Teilprozess eine anorganische Vernetzung der Ausgangskomponenten zur mindestens einen vernetzbaren Vorstufe initiiert wird, vorzugweise durch Sauerstoff, wobei gleichzeitig eine weitere organische Vernetzung der mindestens einen vernetzbaren Vorstufe zum mindestens einen anorganisch-organischen Hybridpolymer erfolgt,
optional in einem zweiten Teilprozess eine Sol-Gel-Reaktion durch Wasser initiiert wird, wobei gleichzeitig die weitere organische Vernetzung der mindestens einen vernetzbaren Vorstufe zum mindestens einen anorganisch-organischen Hybridpolymer erfolgt, und
in einem dritten Teilprozess die mindestens eine vernetzbare Vorstufe und das mindestens eine anorganisch-organische Hybridpolymer durch Plasmaunterstützung oder pyrolytische Unterstützung zu mindestens einer anorganisch-organischen Hybridpolymer-Beschichtung auf der mindestens einen Oberfläche des Substrats abgeschieden werden.

7. Verfahren gemäß einem der vorhergehenden Ansprüche, **dadurch gekennzeichnet, dass** zur Durchführung des Plasma-unterstützten chemischen Gasphasenabscheidung-Prozesses ein Plasma erzeugt wird, indem mindestens ein Plasmagas, vorzugsweise Argon und/oder Stickstoff, durch eine Hochfrequenzentladung ionisiert wird, wobei die Hochfrequenzentladung vorzugsweise durch eine Metallelektrode erfolgt, die eine Durchbohrung aufweist, durch welche das mindestens eine Plasmagas in die Beschichtungskammer eingeleitet wird.

8. Verfahren gemäß einem der vorhergehenden Ansprüche, **dadurch gekennzeichnet, dass** der Plasma-unterstützte chemische Gasphasenabscheidungs-Prozess
- bei einem Druck von 0,1 Pa bis 100 Pa, bevorzugt von 1 Pa bis 10 Pa, und/oder
- bei einer Leistung von 0,005 W/cm² bis 0,5 W/cm², bevorzugt von 0,02 W/cm² bis 0,2 W/cm², und/oder
- für eine Dauer von 1 min bis 100 min, bevorzugt von 10 min bis 50 min,
durchgeführt wird.

9. Verfahren gemäß einem der vorhergehenden Ansprüche, **dadurch gekennzeichnet, dass** der pyrolytisch unterstützte chemische Gasphasenabscheidungs-Prozess
- bei Atmosphärendruck, und/oder
- für eine Dauer von 1 min bis 100 min, bevorzugt von 5 min bis 50 min, und/oder
- bei einer Temperatur in einem Bereich von -10 °C bis 100 °C, durchgeführt wird.

10. Verfahren gemäß einem der vorhergehenden Ansprüche, **dadurch gekennzeichnet, dass** keine UV-Initiatoren verwendet werden.

11. Verfahren gemäß einem der vorhergehenden Ansprüche, **dadurch gekennzeichnet, dass** Schritt a) unter Verwendung eines mehrkanaligen Verdampfersystems oder eines mehrkanaligen Vernebelungssystems durchgeführt wird, welches vorzugsweise Temperaturen bis zu 250 °C ermöglicht.

12. Verfahren gemäß einem der vorhergehenden Ansprüche, **dadurch gekennzeichnet, dass** in Schritt b) die verdampften oder vernebelten Ausgangskomponenten durch separate Gaseinlässe, bevorzugt separate Gasduschen, in die Beschichtungskammer eingebracht werden, wobei sich die separaten Gaseinlässe vorzugsweise in der Nähe des Substrats befinden.

13. Verfahren gemäß einem der vorhergehenden Ansprüche, **dadurch gekennzeichnet, dass**
- die Beschichtungskammer auf einer Temperatur in einem Bereich von 50 °C bis 100 °C, bevorzugt von 60 °C bis 80 °C, gehalten wird, und/oder
- die verdampften oder vernebelten Ausgangskomponenten zwischen Schritt a) und Schritt b) über Rohrleitungen zur Beschichtungskammer transportiert werden, wobei die Rohrleitungen auf einer Temperatur im Bereich von 45 °C bis 95 °C, bevorzugt von 55 °C bis 75 °C, gehalten werden.

14. Beschichtetes Substrat, umfassend ein Substrat mit mindestens einer anorganisch-organischen Hybridpolymer-Beschichtung herstellbar oder hergestellt mit einem Verfahren gemäß einem der vorhergehenden Ansprüche.

15. Beschichtetes Substrat gemäß Anspruch 14, **dadurch gekennzeichnet, dass** die mindestens eine anorganisch-organischen Hybridpolymer-Beschichtung
- eine Schichtdicke von 0,1 bis 10 µm, bevorzugt von 0,5 bis 1,0 µm, und/oder
- einen Kontaktwinkel von 70° bis 120°, bevorzugt von 80° bis 110°, aufweist, und/oder
- ein Fluor/Silicium-Verhältnis von 5,0 bis 15,0, bevorzugt von 7,0 bis 13,0,
aufweist.
